# EUROPEAN PATENT APPLICATION

(11) **EP 2 620 975 A1**
(43) Date of publication of application: **31.07.2013**
(21) Application number: 11826558.6
(22) Date of filing: 13.09.2011
(51) Int. Cl.: H01L 21/316, C01G 25/02, C23C 16/455, H01L 21/8246, H01L 27/105

(54) **THIN FILM PRODUCTION PROCESS AND THIN FILM PRODUCTION DEVICE**

(30) Priority: 21.09.2010 JP 2010210752
(71) Applicant: Ulvac, Inc., Chigasaki-shi Kanagawa 253-8543 (JP)
(72) Inventor: MASUDA, Takeshi, Susono-shi Shizuoka 4101231 (JP); KAJINUMA, Masahiko, Susono-shi Shizuoka 410-1231 (JP); IDENO, Takuya, Susono-shi Shizuoka 410-1231 (JP); ODAJIMA, Nobuhiro, Susono-shi Shizuoka 410-1231 (JP); UCHIDA, Yohei, Susono-shi Shizuoka 410-1231 (JP); SUU, Koukou, Susono-shi Shizuoka 410-1231 (JP)
(74) Representative: Markfort, Iris-Anne Lucie
(86) International application number: PCT/JP2011/005134
(87) International publication number: WO 2012/039107

(57) **Abstract**

[Problem] To provide a thin film production process and a thin film production device, both of which enable the production of a dielectric thin film having small surface roughness. [Solution] This thin film production process comprises: supplying a mixed gas to a substrate (S) that is placed in a chamber (51) and has been heated, wherein the mixed gas comprises a metal raw material gas that serves as a raw material for a dielectric thin film having perovskite-type crystals and an oxidation gas that can react with the metal raw material gas; stopping the supply of the metal raw material gas to the substrate (S); and, subsequent to the stopping of the supply of the metal raw material gas, limiting the supply of the oxidation gas to the substrate (S).

## Description

### Technical Field

The present invention relates to a method of forming a dielectric thin-film such as a PZT (lead zirconate titanate) thin-film, and a thin-film forming apparatus.

### Background Art

In the related art, as a ferroelectric thin-film for use in a ferroelectric random access memory (FeRAM) or the like, a thin-film of lead zirconate titanate (Pb(Zr,Ti)O3; PZT) having a perovskite structure is known. Such dielectric thin-film is formed by a Metal Organic Chemical Vapor Deposition (MOCVD) method.

The MOCVD method is a method of forming the dielectric thin-film by reacting a raw material organic metal gas with an oxidation gas at a high temperature. In order to form the dielectric thin-film with a high quality, it uses a self-alignment region where a composition ratio of the thin-film is less changed even if a flow rate of the raw material gas is changed.

Patent Document 1 describes a MOCVD method of supplying a mixed gas of an organic metal raw material gas, an oxidation gas and a diluent gas to a substrate that has been heated. In the MOCVD method described in Patent Document 1, a combustible gas is also supplied when the mixed gas is supplied to the substrate. As excess oxygen on the surface of the substrate is combusted and discharged, a high quality thin-film can be formed (see paragraphs [0011] and [0025] in Patent Document 1.

Patent Document 1: Japanese Patent Application Laid-open No. 2004-273787

### Summary of Invention

### Problem to be solved by the Invention

When the dielectric thin-film is formed as described above, the dielectric thin-film preferably has a small surface roughness. If the dielectric thin-film has a high surface roughness, the process of forming a ferroelectric memory having, for example, the dielectric thin-film may cause a problem. Also, there is a concern about that electrical properties of the dielectric thin-film are not sufficiently provided, for example.

In view of the circumstances as described above, an object of the present invention is to provide a thin-film forming method and a thin-film forming apparatus, both of which enable the formation of a dielectric thin-film having a small surface roughness.

### Means for solving the Problem

In order to achieve the above-mentioned object, a method of forming a thin-film according to an embodiment of the present invention comprises supplying a mixed gas to a substrate that is placed and heated in a chamber; the mixed gas containing a metal raw material gas that serves as a raw material for a dielectric thin-film having perovskite type crystals and an oxidation gas that is reacted with the metal raw material gas.
The supply of the metal raw material gas to the substrate is stopped.
After stopping the supply of the metal raw material gas, the supply of the oxidation gas to the substrate is regulated.

A thin-film forming apparatus according to an embodiment of the present invention comprises a chamber, a supply mechanism and a gas supply regulating means.
In the chamber, a heated substrate is placed.
The supply mechanism is to supply the substrate heated and placed in the chamber with a mixed gas of a metal raw material gas that serves as a raw material of a dielectric thin-film having a perovskite structure and an oxidation gas that is reacted with the metal raw material gas.
The gas supply regulating means is for stopping the supply of the metal raw material gas to the substrate, and then regulating the supply of the oxidation gas to the substrate.

### Brief Description of Drawings

[Fig. 1] A schematic diagram showing a configuration of a thin-film forming apparatus according to an embodiment of the present invention.
[Fig. 2] A schematic diagram showing a configuration of a multichamber film forming apparatus including the thin-film forming apparatus shown in Fig. 1.
[Fig. 3] Graphs each showing a Pb composition ratio and a Zr composition ratio in a PZT thin-film formed to a flow rate ratio of a Pb raw material gas supplied to a substrate.
[Fig. 4] Photographs of respective surface layers of a PZT thin-film formed by the thin-film forming apparatus shown in Fig. 1 and a PZT thin-film formed by a comparative forming method; and respective measured values of the surface layers.
[Fig. 5] A schematic diagram showing a modification of the thin-film forming apparatus shown in Fig. 1. Mode(s) for Carrying Out the Invention

A method of forming a thin-film according to an embodiment of the present invention includes supplying a heated substrate in a chamber with a mixed gas of a metal raw material gas of a dielectric thin-film including perovskite type crystals and an oxidation gas that is reacted with the metal raw material gas.
The supply of the metal raw material gas to the substrate is stopped.
After stopping the supply of the metal raw material gas, the supply of the oxidation gas to the substrate is regulated.

According to the method of forming a thin-film, it can be inhibited from reacting extra atoms not constituting the perovskite type crystals with the oxidation gas, after stopping the supply of the metal raw material gas. In this way, the extra atoms will not be introduced into a surface layer of the dielectric thin-film, for example, as an oxide, and the dielectric thin-film having a small surface roughness can be formed.

In the regulating step, the supply of the oxidation gas may be stopped or decreased. In this case, the method of forming a thin-film may further include supplying an inert gas to the chamber in response to the stop or the decrease of the oxidation gas supply.

According to the method of forming a thin-film, in response to the stop or the decrease of the oxidation gas supply, the inert gas is supplied to the chamber. The inert gas allows a pressure in the chamber to be adjusted, for example. In this way, a film forming process can be effectively carried out, when dielectric thin-films are sequentially formed on a plurality of substrates.

In the step of supplying the mixed gas, the mixed gas containing the inert gas may be supplied. In this case, in the step of supplying the inert gas in response to the stop or the decrease of the oxidation gas supply, the inert gas contained in the mixed gas may be supplied.

According to the method of forming a thin-film, the mixed gas for use in the formation of the dielectric thin-film contains the inert gas. The inert gas is supplied to the chamber in response to the stop or the decrease of the oxidation gas supply. In this way, a new mechanism for supplying the inert gas becomes unnecessary, thereby easily supplying the inert gas.

In the step of supplying the mixed gas, the mixed gas may be supplied via a supply path that connects a mixer for mixing the metal raw material gas, the oxidation gas and the inert gas to the chamber. In this case, the step of supplying the inert gas may supply the inert gas via the supply path through which the mixed gas is passed.

According to the method of forming a thin-film, the inert gas is supplied to the chamber via the supply path through which the mixed gas is passed. In this way, it can prevent the mixed gas from accumulating at the supply path. As a result, the dielectric thin-film can be stably formed on the substrate.

The dielectric thin-film may be PZT (Pb(Zr, Ti)O3). In this case, the metal raw material may contain a material partly including Pb(dpm)2 and Pb(dibm)2 or at least one of them.

The substrate may be heated at 600°C or more.

A thin-film forming apparatus according to an embodiment of the present invention includes a chamber, a supply mechanism and a gas supply regulating means.
A heated substrate is placed in the chamber.
The supply mechanism is for supplying the heated substrate in the chamber with a mixed gas of a metal raw material gas that serves as a raw material of a dielectric thin-film having a perovskite structure and an oxidation gas that is reacted with the metal raw material gas.
The gas supply regulating means stops the supply of the metal raw material gas to the substrate, and regulates the supply of the oxidation gas to the substrate.

Hereinafter, embodiments according to the present invention will be described with reference to the drawings.

### [Thin-film Forming Apparatus]

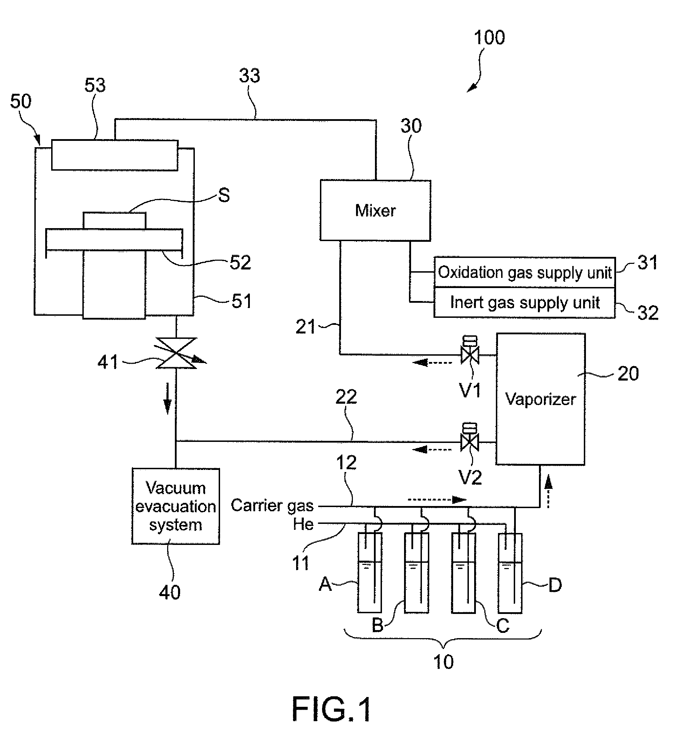

Fig. 1 is a schematic diagram showing a configuration of a thin-film forming apparatus according to an embodiment of the present invention. The thin-film forming apparatus according to the embodiment allows a ferroelectric PZT thin-film to be formed using the MOCVD method.

A thin-film forming apparatus 100 includes a raw material supply unit 10 for supplying an organic solvent solution of an organic metal, and a vaporizer 20 for vaporizing the solution to produce a raw material gas. The thin-film forming apparatus 100 includes a mixer 30 for producing a mixed gas by mixing a raw material gas, an oxidation gas that is reacted with the raw material and an inert gas, and a film forming chamber 50 connected to the mixer 30 via a supply line 33 as a supply path. According to the embodiment, the supply mechanism is configured by the raw material supply unit 10, the vaporizer 20, the mixer 30, and each line and each valve disposed thereon.

The raw material supply unit 10 includes tanks A, B, C and D with which a raw material solution and a solvent of the organic metal is filed, and a supply line 11 for supplying He (helium) to respective tanks (A to D). Also, the raw material supply unit 10 includes a supply line 12 for supplying a carrier gas to transport the solution and the solvent of the metal raw material forced out by a pressure of He supplied to the respective tanks A to D. In the embodiment, N2 (nitrogen) is used as a carrier gas, but is not limited thereto. Other inert gas may be used. In the same manner, the gas supplied to the respective tanks A to D is not limited to He, and other inert gas may be used.

In the embodiment, the tanks A to D are filled with a Pb raw material solution, a Zr raw material solution, a Ti raw material solution and an organic solvent, respectively. As the Pb, Zr and Ti raw material solutions, each metal raw material is dissolved in an n-butyl acetate solution at a concentration of 0.25 mol/L.

As the Pb raw material, Pb(dpm)2, (bisdipivaloyl methanate) lead is used. As the Zr raw material, Zr(dmhd)4, (tetrakis(2,6)dimethyl(3,5)heptane dionate)zirconium is used. As the Ti raw material, Ti(iPrO)2(dpm)2, ((bisisopropoxide)bisdipivaloyl methanate)) titanium is used. As the solvent filled in the tank D, n-butyl acetate is used. Pb(dpm)2 is also referred to as Pb(thd)2, (bis(2,2,6,6)tetramethyl (3,5)heptanedionate) lead.

The metal raw materials dissolved into the solvent are not limited to the above-described materials. For example, the Pb raw material may include Pb(dibm)2, (bisdiisobutyryl methanate) lead, or may partly include both of Pb(dpm)2 and Pb(dibm)2 or at least one of them. The Zr raw material may include thd, (tetrakis(2,2,6,6)tetramethyl(3,5)heptane dionate)zirconium, or may partly include it. The Ti raw material may include Ti(MMP)4, (tetrakis(1)methoxy(2)methyl(2) propoxy) titanium, or may partly include it.

As the solvent for dissolving each metal raw material and a solvent filled in the tank D, toluene, tetrahydrofuran (THF), cyclohexane, ethylcyclohexane, methylcyclohexane or the like may be used instead of n-butyl acetate as described above.

The vaporizer 20 is connected to the raw material supply unit 10 via the supply line 12, and droplets of the metal raw material solution and the solvent are transported from the raw material supply unit 10 to the vaporizer 20. The vaporizer 20 includes a heating means (not shown), which vaporizes the solution and the solvent of the metal raw material transported. In this way, a metal raw material gas is produced. In order to improve vaporization efficiency, a gas, ultrasonic, etc. may be applied to the droplets of the metal raw material solution and the solvent, or the droplets that have become finer via a fine nozzle in advance may be introduced.

As shown in Fig. 1, the vaporizer 20 includes a Run line 21 connected to the mixer 30, and a Vent line 22 connected to a vacuum evacuation system 40. A valve V1 is disposed in the Run line 21, and a valve V2 is disposed in the Vent line 22.

The mixer 30 produces the mixed gas of the metal raw material gas produced by the vaporizer 20, the oxidation gas and the inert gas. Accordingly, an oxidation gas supply unit 31 and an inert gas supply unit 32 are connected to the mixer 30. In the embodiment, 02 (oxygen) is supplied from the oxidation gas supply unit 31, and N2 is supplied from the inert gas supply unit 32. However, as the oxidation gas, dinitrogen monoxide, ozone etc. may be supplied. Also, as the inert gas, argon etc. may be supplied.

The film forming chamber 50 includes a chamber 51 connected to the supply line 33, and a stage 52 disposed in the chamber 51. A shower nozzle 53 is disposed on a ceiling plane of the chamber 51. To the shower nozzle 53, the supply line 33 is connected. The stage 52 and the shower nozzle 53 are disposed facing each other. In the chamber 51, cleaned parts such as a shield (not shown) are disposed.

As shown in Fig. 1, on the stage 52, a substrate S on which the PZT thin-film is formed is placed. The stage 52 has a heating means such as a heater (not shown), and can heat the substrate S placed. In the embodiment, the substrate S placed on the stage 52 is configured of an 8-inch Si substrate on which an SiO2 oxidized film is formed in a thickness of 100 nm, and Ir is formed thereon in a thickness of 70 nm by a sputtering method. However, a size, a material and the like of the substrate are not limited.

The chamber 51 is connected to the vacuum evacuation system 40 including, for example, a dry pump, a turbo molecular pump etc. via a pressure adjusting valve 41. By setting a pressure in the chamber 51 with the pressure adjusting valve 41 as appropriate, it is possible to easily accommodate a variety of film forming pressure conditions.

Each apparatus including each line from the vaporizer 20 to the film forming chamber 50, each valve, the mixer 30 etc. is kept at a high temperature, e.g. 200°C or more, by the heating means (not shown) such that the metal raw material gas vaporized is not liquefied, for example.

The thin-film forming apparatus 100 according to the embodiment includes a regulating unit (not shown) as a gas supply regulating means for regulating each valve and each apparatus as described above. The regulating unit includes a main memory including a CPU (Central Processing Unit), a ROM (Read Only Memory) or a RAM (Random Access Memory) or the like. A regulating signal is output from the regulating unit to each apparatus via, for example, wired or wireless, thereby regulating operations of the thin-film forming apparatus 100.

### [Multichamber Film Forming Apparatus]

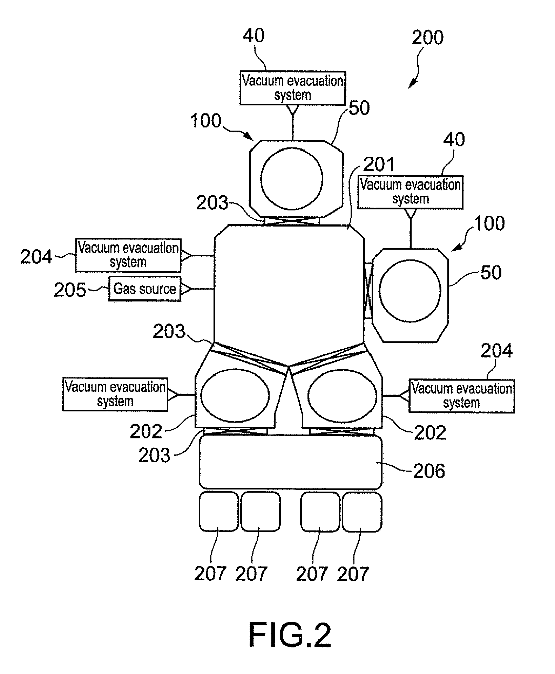

Fig. 2 is a schematic diagram showing a configuration of a multichamber film forming apparatus including the thin-film forming apparatus according to the embodiment. A multichamber film forming apparatus 200 includes a transport chamber 201 on which a transport robot (not shown) capable of transporting the substrate S is placed, and two stock chambers 202 capable of each mounting 25 substrates as a lot. The multichamber film forming apparatus 200 includes two thin-film forming apparatuses 100 as described above, and two film forming chambers 50 are disposed around the transport chamber 201. Each of the film forming chambers 50 and the stock chambers 202 is connected to the transport chamber 201 via a partition valve 203. The number of the stock chambers 202 is not limited to two. More stock chambers or one stock chambers may be disposed around the transport chamber 201.

Each vacuum evacuation system 40 is connected to each film forming chamber 50. Similarly, a vacuum evacuation system 204 is connected to each of the transport chamber 201 and the stock chambers 202. Each chamber can be evacuated inside independently to a vacuum atmosphere. Alternatively, one vacuum evacuation system may be simultaneously used for the transport chamber 201, the film forming chamber 50, and the stock chambers 202 to evacuate inside, for example. In this case, the vacuum evacuation system functions as the vacuum evacuation system 40 as shown in Fig. 1.

A gas source 205 is connected to the transport chamber 201. With a pressure adjusted gas such as the inert gas supplied from the gas source 205, the transport chamber 201 can be adjusted to have a predetermined pressure. An automatic pressure adjusting valve (not shown) disposed at the transport chamber 201 adjusts an internal pressure of the transport chamber 201.

As shown in Fig. 2, the stock chambers 202 are connected to a substrate transport system under atmosphere 206 via valves 203. The substrate transport system under atmosphere 206 includes a transport robot (not shown) for transporting the substrate S on which a film is formed or not between a plurality of wafer cassettes 207 and the stock chambers 202.

When the film forming step is started, the predetermined number of the substrate S is transported to the stock chambers 202 from the wafer cassettes 207 each including 25 wafers by the transport robot disposed on the substrate transport system under atmosphere 206. Each stock chamber 202 into which the substrate S is transported is vacuum evacuated.

Each valve 203 disposed between each stock chamber 202 vacuum evacuated and the transport chamber 201 is opened, and both of the transport chamber 201 and each stock chamber 202 are then vacuum evacuated. 1200 sccm of an adjusting gas such as N2 is supplied from the gas source 205 to the transport chamber 201 to adjust the internal pressure of the transport chamber 201.

In the embodiment, as the film forming pressure conditions, the internal pressure of the film forming chamber 50 is set to about 2 Torr. Correspondingly, the internal pressure of the transport chamber 201 is adjusted to an almost similar pressure as the internal pressure of the film forming chamber 50 or about 5% higher than the internal pressure of the film forming chamber 50. The internal pressure of the film forming chamber 50 is adjusted by N2 supplied from the inert gas supply unit 32. The above-described film forming pressure conditions may be set as appropriate. After the pressure adjustment of the transport chamber 201 is almost ended, the first substrate S is transported to the film forming chamber 501 via the transport chamber 201.

The multichamber film forming apparatus 200 according to the embodiment includes two stock chambers 202. When one stock chamber 202 is filled with the substrates S, the other stock chamber 202 can mount the substrates S. If the substrates S are mounted on the second stock chamber 202, the second stock chamber 202 is vacuum evacuated after the film forming process of the substrates S mounted on the first stock chamber 202 is ended, and the substrates S are again transported to the film forming chamber 50.

### [Operation of Thin-film Forming Apparatus]

When He is supplied from the supply line 11 for supplying He to each of the tanks A to D as shown in Fig. 1, the internal pressure of each of the tanks A to D increases, whereby the raw material solution and the solvent of the organic metal filled in each of the tanks A to D are forced out to the supply line 12 for supplying the carrier gas (N2). The forced droplets of the metal raw material solution and the solvent are regulated for the flow rate by a liquid flow rate regulator or the like, and are transported to the vaporizer 20 by the carrier gas.

Once the film forming step is started, a nozzle flush of the vaporizer 20 is started by the solvent transported by the carrier gas forced out of the tank D. Within about 3 minutes, the vaporizer 20 is prepared to vaporize the metal raw material solution and the solvent. In this case, the valve V2 of the Vent line 22 is opened, a vaporized gas of the solvent and the carrier gas are discarded to the Vent line 22.

When the first substrate S is transported to the film forming chamber 50 and is mounted on the stage 52, the substrate S is heated by the heating means disposed on the stage 52. Within about 3 minutes, the temperature of the substrate is stabilized at the predetermined temperature. According to the embodiment, the substrate S is heated so that the temperature of the substrate S reaches 600°C or more. The temperature of the substrate S heated may be set as appropriate.

The vaporization by the vaporizer 20 is switched from the solvent to the subject metal raw material solution at the controlled flow rate for film forming within 2 minutes before the temperature of the substrate S is converged (the Vent line 22 keeps to be opened).

Once the temperature of the substrate S or a part such as the shower nozzle 53 reaches the predetermined temperature, the valve V2 of the Vent line 22 is closed and the valve V1 of the Run line 21 is opened. The vaporized gas of the subject metal raw material solution vaporized by the vaporizer 20 is supplied to the mixer 30.

In the mixer 30, the vaporized gas supplied from the vaporizer 20, the oxidation gas 02 and the inert gas N2 are mixed at a predetermined mixing ratio (mol ratio). The mixing ratio is set as appropriate in order to provide a desirable crystalline orientation of the PZT thin-film formed, for example.

The mixed gas produced by the mixer 30 is provided to the chamber 51 of the film forming chamber 50 via the supply line 33. The mixed gas is provided to the substrate S heated, and the PZT thin-film having perovskite-type crystals is formed on the substrate S. In the embodiment, the PZT thin-film is formed in a thickness of about 70 nm at a film forming rate of about 15 nm/min. Accordingly, it takes about 300 seconds to form the film. However, the thickness of the PZT thin-film formed, the film forming rate, and the time for the film formation are not limited thereto.

After the film formation, the valve V1 of the Run line 21 is closed, and the valve V2 of the Vent line 22 is opened. Thus, the supply of the vaporized gas of the metal raw material solution to the substrate S in the chamber 51 is stopped, and the vaporized gas is discarded via the Vent line 22.

In the embodiment, after the supply of the metal raw material gas to the substrate S is stopped, the supply of 02 from the oxidation gas supply unit 31 connected to the mixer 30 is regulated. The "regulation" in the embodiment means that the supply of 02 to the substrate S is stopped. Then, a predetermined amount of N2 is supplied from the inert gas supply unit 32, and N2 is supplied to the chamber 51 via the supply line 33 through which the mixed gas is passed. As the amount of N2, the flow rate before the supply of 02 from the oxidation gas supply unit 31 is stopped may be retained, or the amount may be adjusted after the supply of 02 is stopped. Alternatively, the amount of N2 may be set so that the internal pressure of the chamber 51 satisfies the film forming pressure conditions (about 2 Torr).

After a given time elapses from the stop of the supply of the vaporized gas of the metal raw material solution to the chamber 51 and the supply of a predetermined amount of N2 to the chamber 51, the partition valve 203 between the film forming chamber 50 and the transport chamber 201 is opened, and the substrate S film formed is unloaded. According to the embodiment, the substrate S is unloaded after about 60 seconds elapsed, but is not limited thereto. For example, the substrate S may be unloaded after 30 seconds to 120 seconds elapsed. A time took for unloading the substrate S may be set as appropriate depending on the time for the film formation and a possibility of changes in the substrate.

As described above, after a given time elapses from N2 is supplied after the film is formed, the substrate S is unloaded. Thus, the substrate S can be unloaded after the mixed gas remained in the film forming chamber 50 is sufficiently evacuated. This can prevent the mixed gas remained from flowing into the transport chamber 201 and particles etc. from generating, when the substrate S is unloaded.

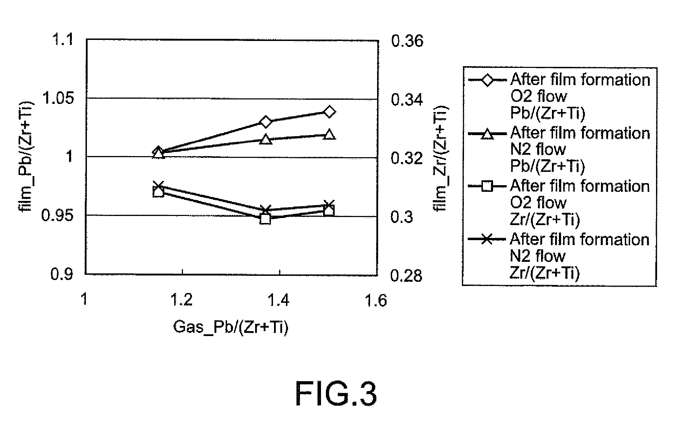

Fig. 3 is graphs each showing a Pb composition ratio, film (Pb/(Zr + Ti)), and a Zr composition ratio, film(Zr/(Zr + Ti)) in the PZT thin-film formed to the flow rate ratio of the Pb raw material gas supplied to a substrate S.

Fig. 3 shows the graph of the PZT thin-film formed by the thin-film forming apparatus 100 according to the embodiment, and the graph of the PZT thin-film formed by a comparative thin-film forming method. The PZT thin-film according to the embodiment is formed by supplying N2 to the chamber 51 after the film formation, i.e., subsequent to the stop of the supply of the metal raw material gas to the film forming chamber 50. On the other hand, the comparative PZT thin-film is formed by supplying 02 to the chamber 51 after stopping the supply of the metal raw material gas to the film forming chamber 50.

When the PZT thin-film that is the dielectric thin-film including the perovskite type crystals is formed, another phase region, the self-alignment region and a PbO precipitated region are emerged in this order from a small flow rate of the Pb raw material gas. In the another phase region, the Pb composition is less than stoichiometric and a crystalline PZT thin-film will not be provided. In the self-alignment region, the Pb composition ratio in the thin-film is less changed even if the flow rate of the Pb raw material gas is changed. In the PbO precipitated region, PbO crystals are precipitated and the Pb composition in the thin-film is rapidly increased. Fig. 3 shows the graphs of measurement results of the self-alignment region among the three regions.

In Fig. 3, the region where the Pb flow rate ratio value is from about 1.15 to about 1.5 is identified as the self-alignment region. However, the self-alignment region is changed based on respective film forming conditions such as the internal pressure of the film forming chamber 50 and the temperature, for example. Therefore, when the PZT thin-film is formed, the Pb flow rate ratio included in the self-alignment region is set as appropriate based on the respective film forming conditions.

As shown in Fig. 3, there is almost no difference as to the Zr composition ratio in the PZT thin-film generated between the PZT thin-film according to the embodiment and the comparative PZT thin-film. In other words, there is almost no change in the Zr composition ratio in the PZT thin-film regardless of using N2 or O2 as the gas supplied to the chamber 51 after the film formation. The Zr composition ratio in the PZT thin-film can be set as appropriate based on the Zr flow rate ratio in the raw material supply unit 10 as shown in Fig. 1. The Zr composition ratio may be set such that the PZT thin-film formed has desirable properties.

On the other hand, the comparative PZT thin-film formed has the Pb composition ratio greater than that of the PZT thin-film formed according to the embodiment. In other words, an increase of the Pb composition in the self-alignment region can be inhibited in the film formed by the method according to the embodiment using N2 as the supplied gas after the film forming as compared with the film formed by the comparative method using O2 as the supplied gas after the film formation.

By the mechanism in the self-alignment region, the PZT crystals are ideally provided, and extra atoms not constituting the perovskite type crystals are excluded. However, excess Pb atoms actually remain, for example, on the surface or crystal grain boundaries of the PZT thin-film. Also, Pb may be attached to parts etc. of the chamber 51.

It is considered that excess Pb atoms remained in the PZT thin-film and Pb atoms volatilized from the PZT thin-film are bonded to 02 on the substrate heated at 600°C or more to easily produce PbO, when 02 is supplied after the film formation under the circumstances. It is also considered that Pb atoms in a gas phase volatilized from Pb attached to the parts in the chamber 51 are bonded to 02. The produced PbO is introduced into the crystal grain boundaries and the surface layer of the PZT thin-film. It is thus considered that the results shown in the graphs of Fig. 3 are provided.

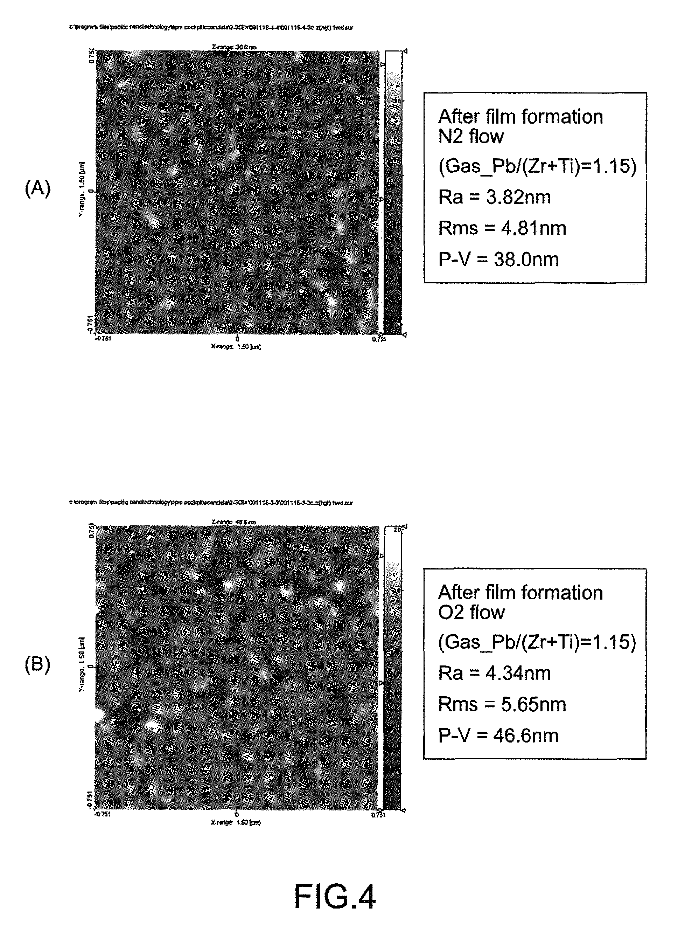

Fig. 4 shows photographs of respective surface layers of the PZT thin-film formed by the thin-film forming apparatus shown 100 according to the embodiment and the PZT thin-film formed by the comparative method, and respective measured values of the surface layers. Fig. 4(A) shows the PZT thin-film according to the embodiment, and Fig. 4 (B) shows the comparative PZT thin-film. Respective photographs are captured by an atomic force microscope.

Respective PZT thin-films shown in Figs. 4(A) and (B) are formed when the flow rate ratio of the Pb raw material gas is 1.15. The measured value Ra is an average surface roughness, and the measured value Rms is a square average roughness. The measured value P-V is a peak-to-valley.

These measured values reveal that the surface roughness of the PZT thin-film formed by the thin-film forming apparatus 100 according to the embodiment is smaller than that of the PZT thin-film formed by the comparative method. As described above, the film formation method according to the embodiment can inhibit the extra Pb atoms not constituting the perovskite type crystals from introducing into the surface layer of the PZT thin-film as PbO after the film formation. This is because the surface roughness of the PZT thin-film according to the embodiment becomes smaller.

As described above, in the thin-film forming apparatus 100 according to the embodiment and the thin-film forming method by the apparatus 100, after the supply of the metal raw material gas to the substrate S is stopped, the supply of 02 to the substrate S is stopped. Thus, it can be inhibited from reacting extra Pb atoms not constituting the perovskite type crystals with 02. In this way, the extra Pb atoms will not be introduced into the surface layer of the PZT thin-film, for example, as the oxide PbO, and the PZT thin-film having a small surface roughness can be formed.

In the method of forming a thin-film according to the embodiment, in response to the stop of the 02 supply after the film formation, the inert gas N2 is supplied to the chamber 51. This allows the internal pressure of the chamber 51 to be adjusted to satisfy the film forming pressure conditions, for example. In this way, the film forming process can be effectively carried out, when the PZT thin-films are sequentially formed on a plurality, e.g., about 300, of substrates S.

In the method of forming a thin-film according to the embodiment, the inert gas supply unit 32 is connected to the mixer 30, as shown in Fig. 1. The mixed gas for forming the PZT thin-film contains the inert gas N2. The N2 is supplied to the chamber 51 in response to the stop of the 02 supply. In this way, a new mechanism for supplying the inert gas to the chamber 51 after the film formation becomes unnecessary, thereby easily supplying the inert gas after the film formation.

In the method of forming a thin-film according to the embodiment, the mixed gas is supplied via the supply line 33 that connects the mixer 30 with the chamber 51. After the film formation, N2 is supplied via the supply line 33 through which the mixed gas is passed. Thus, after stopping the supply of the metal raw material gas, the mixed gas containing the metal raw material gas is forced to supply N2 to the chamber 51. In this way, it can prevent the metal raw material gas from accumulating at the supply line 33. As a result, the metal raw material gas (the mixed gas) accumulated at the supply line is prevented from supplying to the chamber 51 during the N2 is supplied after the film formation, and the PZT thin-film can be stably formed on the substrate S.

The present invention is not limited to the above-described embodiments, and variations and modifications may be made without departing from the scope of the present invention.

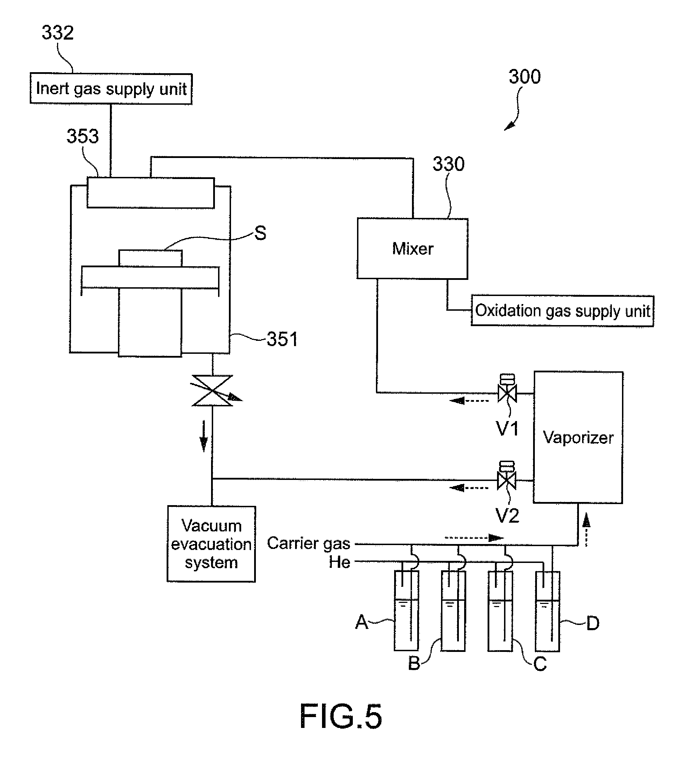

For example, Fig. 5 is a schematic diagram showing a modification of the thin-film forming apparatus 100 shown in Fig. 1. In a thin-film forming apparatus 300, an inert gas supply unit 332 is not connected to a mixer 330, and is separately connected to a shower nozzle 353 of a chamber 351. In the mixer 330, the metal raw material gas is mixed with the oxidation gas. The mixed gas is supplied to the substrate S. In this way, the PZT thin-film is formed on the substrate S. After the film formation, the supply of the mixed gas (the metal raw material gas and the oxidation gas) from the mixer 330 is stopped, and the inert gas is supplied to the chamber from the inert gas supply unit 332. Thus, the inert gas supply unit 332 may be connected to the chamber 351 separately from the mixer 330.

After stopping the supply of the metal raw material gas to the substrate, the inert gas may not be supplied. Even in this case, when the supply of the oxidation gas is stopped after stopping the supply of the metal raw material gas, it can prevent unnecessary Pb atoms from reacting with the oxidation gas after the film formation, and the oxide PbO from introducing into the surface layer of the PZT thin-film. Even if the inert gas is not supplied after the film formation, the oxidation gas is virtually evacuated from the inside of the film forming chamber after the film formation. Under this state, the substrate is transported from the transport chamber.

Alternatively, the mixer may not be disposed, and the metal raw material gas, the oxidation gas supply unit and the inert gas supply unit may be individually connected to the chamber. In this case, the mixed gas of the metal raw material gas, the oxidation gas and the inert gas will be produced in the chamber. After the film formation, the supply of the oxidation gas and the inert gas may be regulated as described above.

In the above-described embodiment, after stopping the supply of the metal raw material gas to the substrate, the supply of the oxidation gas is stopped. However, the supply of the oxidation gas may be decreased after the film formation. In other words, the regulation of the supply of the oxidation gas may include both of the stop and the decrease of the supply of the oxidation gas. By decreasing the supply of the oxidation gas after the film formation, it can be inhibited from reacting extra Pb atoms with the oxidation gas.

According to the above-described embodiment, the PZT thin-film is formed using the thin-film forming apparatus 100. However, the present invention is applicable to the formation of the thin-film other than the PZT thin-film formed as the dielectric thin-film having a perovskite structure. Examples include the dielectric thin-film of lanthanum-doped lead zirconate titanate ((Pb, La)(Zr, Ti)O3; PLZT), strontium bismuth tantalite (SrBi2, Ta2, 09; SBT) and the like.

As the thin-film forming apparatus 100 according to the embodiment of the present invention, the multichamber film forming apparatus 200 is illustrated above, as shown in Fig. 2. However, the thin-film forming apparatus 100 of the embodiment may be disposed on a substrate processing apparatus including a plurality of process apparatuses such as an etching process apparatus and a cleaning process apparatus. Examples of the substrate process apparatus include a cluster tool type substrate process apparatus and an in-line type substrate process apparatus.

### Description of Symbols

- S: substrate
- 10: raw material supply unit
- 11, 12, 33: supply line
- 12: supply line
- 20: vaporizer
- 21: Run line
- 22: Vent line
- 30, 300: mixer
- 31: oxidation gas supply unit
- 32, 332: inert gas supply unit
- 51, 351: chamber
- 100, 300: thin-film forming apparatus

## Claims

1. A method of forming a thin-film, comprising:
supplying a mixed gas to a substrate that is placed and heated in a chamber, the mixed gas containing a metal raw material gas that serves as a raw material for a dielectric thin-film having perovskite-type crystals and an oxidation gas that is reacted with the metal raw material gas;
stopping the supply of the metal raw material gas to the substrate; and
regulating the supply of the oxidation gas to the substrate after stopping the supply of the metal raw material gas.

2. The method of forming a thin-film according to claim 1,
wherein
in the regulating step, the supply of the oxidation gas is stopped or decreased,
the method of forming a thin-film further comprising:
supplying an inert gas to the chamber in response to the stop or the decrease of the oxidation gas supply.

3. The method of forming a thin-film according to claim 2,
wherein
in the step of supplying a mixed gas, the mixed gas containing the inert gas is supplied,
in the step of supplying an inert gas to the chamber in response to the stop or the decrease of the oxidation gas supply, the inert gas contained in the mixed gas is supplied.

4. The method of forming a thin-film according to claim 3,
wherein
in the step of supplying the mixed gas, the mixed gas is supplied via a supply path that connects a mixer for mixing the metal raw material gas, the oxidation gas and the inert gas to the chamber, and wherein
in the step of supplying the inert gas, the inert gas via the supply path through which the mixed gas is passed is supplied.

5. The method of forming a thin-film according to any one of claim1 1 to 4, wherein
the dielectric thin-film is PZT (Pb(Zr, Ti)O3), and wherein
the metal raw material contain a material partly including Pb(dpm)2 and Pb(dibm)2 or at least one of them.

6. The method of forming a thin-film according to any one of claim1 1 to 5, wherein
the substrate is heated at 600°C or more.

7. A thin-film forming apparatus, comprising:
a chamber in which a heated substrate is placed;
a supply mechanism for supplying the heated substrate in the chamber with a mixed gas of a metal raw material gas that serves as a raw material of a dielectric thin-film having perovskite crystals and an oxidation gas that is reacted with the metal raw material gas; and
a gas supply regulating means for stopping the supply of the metal raw material gas to the substrate, and regulating the supply of the oxidation gas to the substrate.
